# EUROPEAN PATENT SPECIFICATION

(11) **EP 3 216 644 B1**
(45) Date of publication and mention of the grant of the patent: **13.01.2021**
(21) Application number: 15857410.3
(22) Date of filing: 09.11.2015
(51) Int. Cl.: B60M 3/04, B60M 3/02, B60L 3/04, H02H 3/38, H02H 7/26

(54) **DISTRIBUTED PROTECTION SYSTEM FOR POWER SUPPLY AT SECTIONS OF ELECTRIFIED RAILWAY PROPULSION SYSTEM**
VERTEILTES SCHUTZSYSTEM ZUR ENERGIEVERSORGUNG AN ABSCHNITTEN EINES ELEKTRIFIZIERTEN EISENBAHNANTRIEBSSYSTEMS
SYSTÈME DE PROTECTION DISTRIBUÉ POUR UNE ALIMENTATION ÉLECTRIQUE AU NIVEAU DE SECTIONS D'UN SYSTÈME DE PROPULSION DE CHEMIN DE FER ÉLECTRIFIÉ

(30) Priority: 07.11.2014 CN 201410624679
(43) Date of publication of application: 13.09.2017
(73) Proprietor: Southwest Jiaotong University, Sichuan 610031 (CN); LI, Qunzhan, Jinniu District Chengdu Sichuan 610031 (CN)
(72) Inventor: LI, Qunzhan, Chengdu, Sichuan 610031 (CN)
(74) Representative: Ström & Gulliksson AB
(86) International application number: PCT/CN2015/000767
(87) International publication number: WO 2016/070492

(56) References cited:
- WO-A1-2013/041010
- CN-A- 102 963 271
- CN-A- 102 963 271
- CN-A- 103 625 309
- CN-A- 104 325 896
- CN-U- 203 039 357
- JP-A- 2011 111 137
- US-A1- 2014 232 191

## Description

### Technical Field

The invention relates to the protection technology for the traction network of alternative current(AC) electrified railway, and more particularly, involves the method and device of the distributed protection system for the segmented power supply network in electrified railway.

### Background

The traction power supply system in electrified railway is composed of traction substations and traction network. The traction network which directly supplies power is composed of OCS (Overhead Contact System), rails and ground. To improve its capacity of power supply, reduce the voltage and energy cost, and keep the relative independence of the OCS for up and down lines, the OCS for up and down lines are normally connected in parallel at the end terminal of the traction network in double-track railway (section post). However, when a fault occurs in the OCS for up (or down) line, the feeder protective devices will make the feeder circuit breakers for up (or down) line in traction substations and the circuit breakers in section posts trip off. In this way, a power failure of the whole OCS for the up (or down) line will be caused, which might stop all the trains' operation. To minimize the areas with power failure, the applicant proposed the invention--"A method of the segmented power supply network and its status supervision for double-track railway with paralleling traction network at the end terminal" (CN 203039357), where the OCS for up and down lines are divided into segments. When a fault occurs, only the faulty segment needs to be isolated, while other normal segments remain supplying electricity. It will greatly increase the reliability, and ensure the trains' normal operation. It is to send the data of different segments to traction substations and dispatching center, in which the data is centrally processed, by the local measurement and control unit via data synchronous collection and a transmission network in this method. After the traction network's fault and where the fault occurring are identified, an operation order will be sent to isolate the fault. Currently, traction substations adopt phase alternating connection when connected to power system and the voltage in different phases is adopted for each arm in traction side. Therefore, the traction network is not continuous, and there are only a few segments installed, which makes it convenient and effective to find and isolate the faults. When the cophase traction power supply mode is adopted in electrified railway, the traction network will be continuous and the quantity of segments will increase. Therefore, it will be difficult for the synchronous data to be collected and delivered, as well as the faulty information to be centrally processed in real time, even more, which might not be accomplished.

US20140232191 discloses a method for central processing of a decentralized measurement. These will all affect the method's practicability. Thus, the problems for this invention to be solved include that how to identify, isolate and clear the faults timely and accurately; how to make sure the real-time operation will not be affected by the quantity of segments; and how to guarantee the normal power supply in normal segments to the utmost extent.

### Summary of Invention

The main purpose of the embodiment of the invention is to provide a distributed protection system for the segmented power supply network in electrified railway to overcome the disadvantages of the current technology. The distributed protection system can identify the different types and the locations of faults timely and accurately, and then isolate and clear the faults quickly, enhance the reliability of power supply, ensure the trains operate safely and punctually. The real time performance of this distributed protection system will not be affected by the quantity of the segments of the traction network. These offer the key technological supports for the promotion and application of cophase traction power supply system in electrified railways.

This invention solves the technical problems by the methods below:
A distributed protection system for the segmented power supply network in electrified railway, of which the composition and relation comprising: the OCS of traction network in electrified railway is divided into several segments FD corresponding to railway sections, adding OCS sectionalizers FDQ and sub-section posts KB between the segments FD. The sub-section post KB includes a circuit breaker DL, a current transformer LH, a potential transformer YH, and a measurement and control unit CK. The circuit breaker DL and the current transformer LH connect in series, and the circuit breaker DL and current transformer LH bridge over the OCS sectionalizer FDQ, the OCS sectionalizer FDQ cascades in the traction network, which makes the trains continuously run through with electricity. The circuit breaker DL is normally in "on" state. The potential transformer YH connects to the OCS T in parallel. In each sub-section post, the potential transformers are of the same type and transformation ratio, and the current transformers are of the same type and transformation ratio as well, wherein, the secondary side of the potential transformer YHₖ and the secondary side of the current transformer LHₖ in the sub-section post KBₖ, the secondary side of the current transformer LHₖ₋₁ in the section post KBₖ₋₁ in left adjacent, the secondary side of the current transformer LHₖ₊₁ in the sub-section post KBₖ₊₁ in right adjacent are all connected to the input terminals of the measurement and control unit CKₖ; the output terminals of the measurement and control unit CKₖ are connected to the control unit of the circuit breaker DLₖ in the sub-section post KBₖ. Each measurement and control unit is connected to the traction substations or dispatching center through a transmission network. The absolute value of the current difference between the current measured at the secondary side of the current transformer LHₖ in the sub-section post KBₖ and the current measured at the secondary side of the current transformer LHₖ₋₁ in the sub-section post KBₖ₋₁ in left adjacent is defined as longitudinal differential current I_{z}. The absolute value of the current difference between the current measured at the secondary side of the current transformer LHₖ in the sub-section post KBₖ and the current measured at the secondary side of the current transformer LHₖ₊₁ in the sub-section post KBₖ₊₁ in right adjacent is defined as longitudinal differential current I_{y}. The measurement and control unit CKₖ is applied to the regulations below:

When the longitudinal differential current I_{z} is not less than I_{dz}, the set value of longitudinal differential current, meanwhile, U_{Tk}, the voltage on OCS measured at the secondary side of the potential transformer YHₖ in the sub-section post KBₖ, is less than the specific value U_{dz}, the measurement and control unit CKₖ identifies there is a short-circuit fault occurring in the OCS in segment FDₖ between the sub-section post KBₖ and the sub-section post KBₖ₋₁ in left adjacent, the measurement and control unit CKₖ then drives the control terminals of the circuit breaker DLₖ in the sub-section post KBₖ to switch off the circuit breaker DLₖ. Otherwise, the circuit breaker DLₖ will remain in "on" state.

When the longitudinal differential current I_{y} is not less than I_{dz}, the set value of longitudinal differential current, meanwhile, U_{Tk}, the voltage on OCS measured at the secondary side of the potential transformer YHₖ in sub-section post KBₖ, is less than the specific value U_{dz}, the measurement and control unit CKₖ identifies there is a short-circuit fault occurring in the OCS in segment FDₖ₊₁ between the sub-section post KBₖ and the sub-section post KBₖ₊₁ in right adjacent, the measurement and control unit CKₖ then drives the control terminals of the circuit breaker DLₖ in the sub-section post KBₖ to switch off the circuit breaker DLₖ. Otherwise, the circuit breaker DLₖ will remain in "on" state.

The OCS segments of traction network in electrified railway are corresponding to railway sections (around 10km). The operation principles are that: when U_{T}, the voltage on OCS, is not less than the specific value U_{dz}, the train L works, otherwise, the train L will stop working; when U_{T}, the voltage on OCS, is less than the specific value U_{dz}, which will cause the train to stop working, the short circuit in OCS will be the only circuit path for the current, therefore, the protection method based on the differential current in the OCS between adjacent segments can be used to identify the fault when the low voltage appears, i.e., U_{T}, the voltage on OCS, is less than the specific value U_{dz}. Moreover, the faulty segments can be isolated by switching off the circuit breaker. Specifically, the absolute value of the current difference between the current measured at the secondary side of the current transformer LHₖ in the sub-section post KBₖ and the current measured at the secondary side of the current transformer LHₖ₋₁ in the sub-section post KBₖ₋₁ in left adjacent is defined as longitudinal differential current When the longitudinal differential current I_{z} is not less than I_{dz}, the set value of longitudinal differential current I_{dz}, meanwhile, U_{Tk}, the voltage on OCS measured at the secondary side of the potential transformer YH_{K} in the sub-section post KBₖ, is less than the specific value U_{dz}, the measurement and control unit CKₖ identifies there is a short-circuit fault occurring in the OCS in segment FDₖ between the sub-section post KBₖ and the sub-section post KBₖ₋₁ in left adjacent, the measurement and control unit CKₖ then drives the control terminal of the circuit breaker DLₖ in the sub-section post KBₖ to switch off the circuit breaker DLₖ. Otherwise, the circuit breaker DLₖ will remain in "on" state. The absolute value of the current difference between the current measured at the secondary side of the current transformer LHₖ in the sub-section post KBₖ and the current measured at the secondary side of the current transformer LHₖ₊₁ in the sub-section post KBₖ₊₁ in right adjacent is defined as longitudinal differential current I_{y}. When the longitudinal differential current I_{y} is not less than I_{dz}, the set value of longitudinal differential current, meanwhile, U_{Tk}, the voltage on OCS measured at the secondary side of the potential transformer YHₖ in the sub-section post KBₖ, is less than the specific value U_{dz}, the measurement and control unit CKₖ identifies there is a short-circuit fault occurring in the OCS in segment FDₖ₊₁ between the sub-section post KBₖ and the sub-section post KBₖ₊₁ in right adjacent, the measurement and control unit CKₖ then drives the control terminal of the circuit breaker DLₖ in the sub-section post KBₖ to switch off the circuit breaker DLₖ. Otherwise, the circuit breaker DLₖ will remain in "on" state.

U_{dz}, the specific value of the voltage on OCS is determined by the technical parameters of train's dynamic system. For the trains running on the electrified railways, of which the rated voltage is 25kV for normal operation, U_{dz} is normally set between 17-19 kV.

To set the value of longitudinal differential current, there are some factors need to be considered, including the effect of capacitance between no-load-contact-lines and ground, the types of instrument transformer, measurement deviation, etc. Actually, the set value of longitudinal differential current is very little.

Compared with the current technology, the benefits of the present invention are as follows:
1. The fault can be identified, distinguished and isolated timely and accurately, and the selectivity, speed and sensitivity of relay protection system can be improved. It can also ensure the normal power supply for normal segments and isolate the faulty segment, which can decrease the influence on railway operation and enhance the reliability of traction power supply.
2. This invention is a kind of distributed protection system for the segmented power supply network. Compared with centralized protection system, its real-time performance won't be affected by the quantity of segments of the traction network.
3. The relative low investment and easy to implement are the advantages in this invention, no matter in new line or old line.

In conjunction with the accompanying figures and specific embodiments, further description of the present invention is given below.

### Brief Description of Drawings

Figure 1 illustrates the structure of segmented power supply for the OCS and sub-section posts with one embodiment of the current invention.
Figure 2 illustrates the structure of measurement and control unit of sub-section posts with one embodiment of the current invention.
Figure 3 illustrates the applying process of the OCS segments and sub-section posts in double-track railway power supply with one embodiment of the current invention.
Figure 4 illustrates the flowchart with one embodiment of the current invention.

### Detailed Description

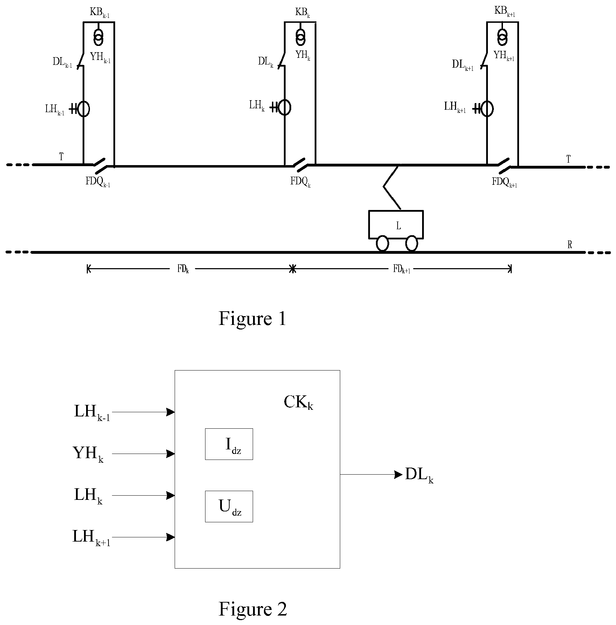

In Figure 1, one embodiment of the current invention is illustrated. Corresponding to railway sections(around 10 km), the OCS of the traction network in electrified railway is divided into several segments FD, adding OCS sectionalizers FDQ and sub-section posts KB between the segments FD. The sub-section post KB includes a circuit breaker DL, a current transformer LH, a potential transformer YH and a measurement and control unit CK. The circuit breaker DL and the current transformer LH connect in series, and the circuit breaker DL and the current transformer LH bridge over the OCS sectionalizer FDQ, the OCS sectionalizer FDQ cascades in the traction network, which makes the trains continuously run through with electricity. The circuit breaker DL is normally in "on" state. The potential transformer YH connects to the OCS T in parallel. The potential transformers are of the same type and transformation ratio, and the current transformers are of the same type and transformation ratio as well.

Figure 2 shows the structure of measurement and control unit in the sub-section post. The secondary side of the potential transformer YHₖ and the secondary side of the current transformer LHₖ in the sub-section post KBₖ, the secondary side of the current transformer LHₖ₋₁ in the sub-section post KBₖ₋₁ in left adjacent, the secondary side of the current transformer LHₖ₊₁ in the sub-section post KBₖ₊₁ in right adjacent are all connected to the input terminals of the measurement and control unit CKₖ; the output terminals of the measurement and control unit CKₖ are connected to the control unit of the circuit breaker DLₖ in the sub-section post KBₖ. Each measurement and control unit is connected to the traction substations or dispatching center through the transmission network.

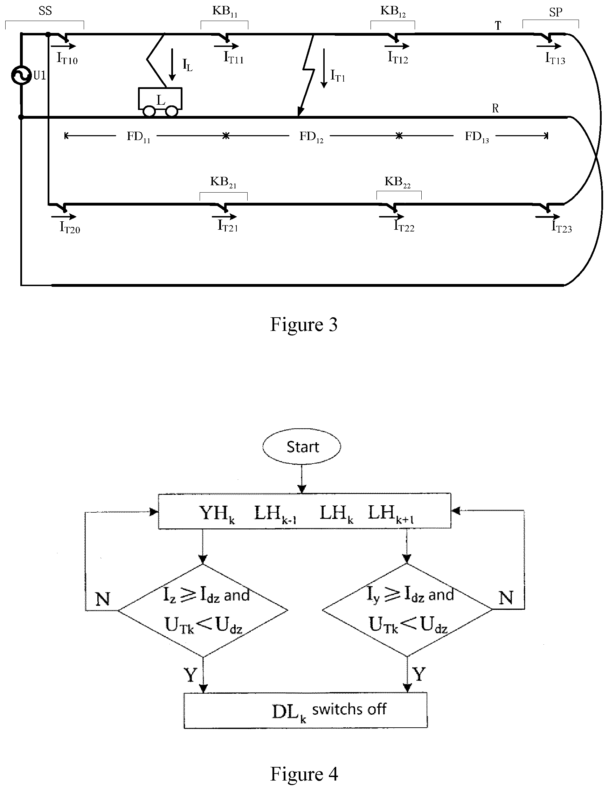

Figure 3 shows the application of the power supply segments and sub-section posts in double-track railway with one embodiment of the current invention. Corresponding to Figure 2, the secondary side of the potential transformer YH₁₁ and the secondary side of the current transformer LH₁₁ in the sub-section post KB₁₁ in up line, the secondary side of the current transformer in the sub-scction post in left adjacent (traction substation, SS), the secondary side of the current transformer LH₁₂ in the sub-section post KB₁₂ in right adjacent are all connected to the input terminals of the measurement and control unit CK₁₁. The secondary side of the potential transformer YH₁₂ and the secondary side of the current transformer LH₁₂ in the sub-section post KB₁₂ in up line, the secondary side of the current transformer LH₁₁ in the sub-section post KB₁₁ in left adjacent, the secondary side of the current transformer in the sub-section post in right adjacent (section post, SP) are all connected to the input terminals of the measurement and control unit CK₁₂. When there is a short-circuit fault occurring in segment FD₁₂, at the position as shown in Figure 3, U_{T11}, the voltage on OCS measured at the secondary side of the potential transformer YH₁₁ in the sub-section post KB₁₁, is less than the specific value U_{dz}, and the longitudinal differential current I_{z} is not less than I_{dz}, the set value of longitudinal differential current. The measurement and control unit CK₁₁ in the sub-section post KB₁₁ then drives the control terminal of the circuit breaker DL₁₁ to switch off the circuit breaker DL₁₁. At the same time, U_{T12}, the voltage on OCS measured at the secondary side of the potential transformer YH₁₂ in the sub-section post KB₁₂, is less than the specific value U_{dz}, and the longitudinal differential current I_{z} is not less than I_{dz} , the set value of longitudinal differential current, the measurement and control unit CK₁₂ in the sub-section post KB₁₂ then drives the control terminal of the circuit breaker DL₁₂ to switch off the circuit breaker DL₁₂, which can isolate the short-circuit fault in segment FD₁₂. The sub-section post KB₁₁ in the sub-section post in left adjacent (traction substation, SS) and the sub-section post KB₁₂ in the sub-section post in right adjacent (section post, SP) can sequentially provide the power supply for normal segments FD₁₁ and FD₁₃, respectively. L presents the train and I_{L} presents the current of the train L. I_{Tk} presents the OCS current measured at the secondary side of current transformer in sub-section post KBₖ.

Figure 4 illustrates the workflow of the present invention. According to the operation principle, when U_{T}, the voltage on OCS, is not less than the specific value U_{dz}, the train L works, otherwise, the train L will stop working; when U_{T}, the voltage on OCS, is less than the specific value U_{dz}, which will cause the train to stop working, the short circuit in OCS will be the only circuit path for the current, therefore, the protection method based on the differential current in the OCS between adjacent segments can be used to identify the fault when the low voltage appears, i.e., U_{T}, the voltage on OCS, is less than the specific value U_{dz}. Moreover, the faulty segment can be isolated by switching off the circuit breaker. The details are illustrated as follows: the absolute value of the current difference between the current measured at the secondary side of the current transformer LHₖ in the sub-section post KBₖ, and the current measured at the secondary side of the current transformer LHₖ₋₁ in the sub-section post KBₖ₋₁ in left adjacent is defined as longitudinal differential current When I_{z} is not less than I_{dz}, the set value of longitudinal differential current, meanwhile, U_{Tk}, the voltage on OCS measured at the secondary side of the potential transformer YHₖ in the sub-section post KBₖ, is less than the specific value U_{dz}, the measurement and control unit CKₖ identifies there is a short-circuit fault occurring in the OCS in segment FDₖ between the sub-section post KBₖ and the sub-section post KBₖ₋₁ in left adjacent. The measurement and control unit CKₖ then drives the control terminal of the circuit breaker DLₖ in the sub-section post KBₖ to switch off the circuit breaker DLₖ. Otherwise, it will remain in "on" state. The absolute value of current difference between the current measured at the secondary side of the current transformer LHₖ in the sub-section post KBₖ and the current measured at the current transformer LHₖ₊₁ in the sub-section post KBₖ₊₁ in right adjacent is defined as longitudinal differential current I_{y}. When the longitudinal differential current I_{y} is not less than I_{dz}, the set value of longitudinal differential current, meanwhile, U_{Tk}, the voltage on OCS measured at the secondary side of the potential transformer YHₖ in the sub-section post KBₖ, is less than the specific value U_{dz}, the measurement and control unit CKₖ identifies there is a short-circuit fault occurring in the OCS in segment FDₖ₊₁ between the sub-section post KBₖ and the sub-section post KBₖ₊₁ in right adjacent, the measurement and control unit CKₖ then drives the control terminal of the circuit breaker DLₖ in the sub-section post KBₖ to switch off the circuit breaker DLₖ . Otherwise, it will remain in "on" state.

For instance, as shown in Figures 2, 3, 4, according to the technical parameters of the dynamic system of the train L, U_{dz}, the specific value of the voltage on OCS is set to 18kV, which means the train will work when U_{T}, the voltage on OCS, is not less than 18kV, otherwise, the train will not work. According to the parameters of the traction network, the types of current transformers, and the measurement deviation, I_{dz}, the set value of longitudinal differential current I_{y}, is set to 0.8A. When U_{T11}, the voltage on OCS measured at the secondary side of the potential transformer YH₁₁ in the sub-scction post KB₁₁, is less than U_{dz} (U_{dz} =18kV), and the longitudinal differential current I_{y} (I_{y}= I I_{T11}-I_{T12}|) is not less than I_{dz} (I_{dz} =0.8A), the measurement and control unit CK₁₁ in the sub-section post KB₁₁ then drives the control terminal of the circuit breaker DL₁₁ to switch off the circuit breaker DL₁₁. Meanwhile, when U_{T12}, the voltage on OCS measured at the secondary side of the potential transformer YH₁₂ in the sub-section post KB₁₂, is less than U_{dz} (U_{dz} =18kV), and the longitudinal differential current I_{z} (I_{z}= |I_{T11}-I_{T12}|) is not less than I_{dz} (I_{dz} =0.8A), the measurement and control unit CK₁₂ in the sub-section post KB₁₂ then drives the control unit of the circuit breaker DL₁₂ to switch off the circuit breaker DL₁₂. Therefore, the short-circuit fault in segment FD₁₂ can be isolated. The sub-section post KB₁₁ in the sub-section post in left adjacent (traction substation, SS), and the sub-section post KB₁₂ in the sub-section post in right adjacent (section post, SP) can sequentially provide the power supply for normal segments FD₁₁ and FD₁₃, respectively.

Moreover, the longitudinal differential current I_{z} is the absolute value of current difference between the current measured at the secondary side of the current transformer LHₖ in the sub-section post KBₖ and the current measured at the secondary side of the current transformer LHₖ₋₁ in the sub-section post KBₖ₋₁ in left adjacent. The longitudinal differential current I_{y} is the absolute value of current difference between the current measured at the secondary side of the current transformer LHₖ in the sub-section post KBₖ and the current measured at the secondary side of the current transformer LHₖ₊₁ in the sub-section post KBₖ₊₁ in right adjacent. Thus, the values of the current measured at the secondary sides of the current transformers in adjacent sub-section posts can distinguish the types and the locations of the faults. For example, when the longitudinal differential current I_{z} is not less than the set value I_{dz}, and U_{Tk}, the voltage on OCS measured at the secondary side of the potential transformer YHₖ in the sub-section post KBₖ, is less than the specific value U_{dz}, there is a short-circuit fault occurring in the OCS in segment FDₖ between the sub-section post KBₖ and the sub-section post KBₖ₋₁ if the current measured at the secondary side of the current transformer LHₖ in the sub-section post KBₖ and the current measured at the secondary side of the current transformer LHₖ₋₁ in the sub-section post KBₖ₋₁ in left adjacent are both greater than 0 (or a specified value, which is established considering some factors, such as the types of current transformers and measurement deviation, cct. the same below). If one of the currents is greater than 0 and the other is equal to 0, there is a short-circuit fault in the segment which provides the current greater than 0 and there is a open-circuit fault in the segment which provides the current equal to 0. Meanwhile, according to the short-circuit current which is more than 0 and the short-circuit voltage on OCS measured at the secondary side of the potential transformer YHₖ, the short-circuit impedance can be calculated and the location of short-circuit fault can be determined. In addition, according to the standards and particular demands, it is essential to reclose the circuit breaker after the measurement and control unit drives the control unit of circuit breaker to switch off the circuit breaker, in order to eliminate the effect caused by transient faults.

All the message about short circuits, open circuits and signals of circuit breakers can be transferred to the nearest traction substation by the corresponding measurement and control unit through the transmission network, or the measurement and control unit can send alarm signals to the dispatching center. To save the space and the cost, in the field application, the measurement and control unit CKₖ can be realized by existing microcomputer protection devices or measurement and control devices . The functions can be performed by changing the application software. Furthermore, some measures can be adopted in order to avoid the disconnection at the secondary sides of current transformers or potential transformers.

## Claims

1. A distributed protection system for the segmented power supply network in electrified railway, wherein the distributed protection system for the segmented power supply network in electrified railway comprises:
the OCS, Overhead Contact System, of traction network in electrified railway is divided into several segments (FD) corresponding to railway sections, adding OCS sectionalizers (FDQ) and sub-section posts (KB) between the segments (FD); the sub-section post (KB) includes a circuit breaker (DL), a current transformer (LH), a potential transformer (YH), and a measurement and control unit (CK); the circuit breaker (DL) and the current transformer (LH) connect in series, and the circuit breaker (DL) and the current transformer (LH) are connected in parallel with the OCS sectionalizer (FDQ), the OCS sectionalizer (FDQ) cascades in the traction network, which makes the trains continuously run through with electricity; the circuit breaker (DL) is normally in on state; the potential transformer (YH) connects to the OCS T in parallel; in all sub-section posts, the potential transformers are of the same type and transformation ratio, and the current transformers are of the same type and transformation ratio as well;
wherein the output terminals of the measurement and control unit (CKₖ) are connected to the control unit of the circuit breaker (DLₖ) in the sub-section post (KBₖ); each measurement and control unit is connected to the traction substations or dispatching center through a transmission network; the absolute value of the current difference between the current measured at the secondary side of the current transformer (LHₖ) in the sub-section post (KBₖ) and the secondary side of the current transformer (LHₖ₋ᵢ) in the sub-section post (KBₖ₋ᵢ) in left adjacent is defined as longitudinal differential current (I_{z}), the absolute value of the current difference between the current measured at the secondary side of the current transformer (LHₖ) in the sub-section post (KBₖ) and the secondary side of the current transformer (LHₖ₊ᵢ) in the sub-section post (KBₖ₊ᵢ) in right adjacent is defined as longitudinal differential current (I_{y});
**characterized in that** the secondary side of the potential transformer (YHₖ) and the secondary side of the current transformer (LHₖ) in the sub-section post (KBₖ), the secondary side of the current transformer (LHₖ₋ᵢ) in the sub-section post (KBₖ₋ᵢ) in left adjacent, the secondary side of the current transformer (LHₖ₊ᵢ) in the sub-section post (KBₖ₊ᵢ) in right adjacent are all connected to the input terminals of the measurement and control unit (CKₖ);
the measurement and control unit (CKₖ) identifies whether there is a short-circuit fault occurring in the OCS in segment (FDₖ) between the sub-section post (KBₖ) and the sub-section post (KBₖ₋ᵢ) in left adjacent according to the longitudinal differential current (I_{z}) and (UTₖ), the voltage on OCS measured at the secondary side of the potential transformer (YHₖ) in sub-section post (KBₖ), the measurement and control unit (CKₖ) drives the control terminals of the circuit breaker (DLₖ) in the sub-section post (KBₖ) to switch off the circuit breaker (DLₖ) if there is a short-circuit fault, otherwise, the circuit breaker (DLₖ) will remain in on state;
the measurement and control unit (CKₖ) identifies whether there is a short-circuit fault occurring in the OCS in segment (FDₖ₊ᵢ) between the sub-section post (KBₖ) and the sub-section post (KBₖ₊ᵢ) in right adjacent according to the longitudinal differential current (I_{y}) and (UTₖ) the voltage on OCS measured at the secondary side of the potential transformer (YHₖ) in sub-section post (KBₖ), the measurement and control unit (CKₖ) drives the control terminal of the circuit breaker (DLₖ) in the sub-section post (KBₖ) to switch off the circuit breaker (DLₖ) if there is a short-circuit fault, otherwise, the circuit breaker (DLₖ) will remain in on state.

2. The distributed protection system for the segmented power supply network in electrified railway according to claim 1, wherein the measurement and control unit CKₖ identifies whether there is a short-circuit fault occurring in the OCS in segment FDₖ between the sub-section post KBₖ and the sub-section post KBₖ₋₁ in left adjacent according to the longitudinal differential current I_{z} and U_{Tk}, the voltage on OCS measured at the secondary side of the potential transformer YHₖ in sub-section post KBₖ, comprises:
the measurement and control unit CKₖ identifies there is a short-circuit fault occurring in the OCS in segment FDₖ between the sub-section post KBₖ and the sub-section post KBₖ₋₁ in left adjacent, on condition that the longitudinal differential current I_{z} is not less than I_{dz}, the set value of longitudinal differential current, meanwhile, U_{Tk}, the voltage on OCS measured at the secondary side of the potential transformer YHₖ in sub-section post KBₖ, is less than the specific value U_{dz}.

3. The distributed protection system for the segmented power supply network in electrified railway according to claim 1, wherein the measurement and control unit CKₖ identifies whether there is a short-circuit fault occurring in the OCS in segment FDₖ₊₁ between the sub-section post KBₖ and the sub-section post KBₖ₊₁ in right adjacent according to the longitudinal differential current I_{y} and U_{Tk}, the voltage on OCS measured at the secondary side of the potential transformer YHₖ in sub-section post KBₖ, comprises:
the measurement and control unit CKₖ identifies there is a short-circuit fault occurring in the OCS in segment FDₖ₊₁ between the sub-section post KBₖ and the sub-section post KBₖ₊₁ in right adjacent, on condition that the longitudinal differential current I_{y} is not less than I_{dz}, the set value of longitudinal differential current, meanwhile, U_{Tk}, the voltage on OCS measured at the secondary side of the potential transformer YHₖ in sub-section post KBₖ, is less than the specific value U_{dz}.

4. The distributed protection system for the segmented power supply network in electrified railway according to claim 2 or 3, wherein I_{dz}, the set value of longitudinal differential current, is 0.8A or 0A, the specific value U_{dz} is 18kV.

## Patentansprüche

1. Verteiltes Schutzsystem zur Energieversorgung an Abschnitten eines elektrifizierten Eisenbahnantriebsystems, wobei das verteilte Schutzsystem zur Energieversorgung an Abschnitten eines elektrifizierten Eisenbahnantriebsystems umfasst:
dass das OCS, Oberleitungssystem, des Traktionsnetzwerks elektrifizierter Eisenbahnantriebssysteme in mehrere Abschnitte (FD) unterteilt ist, welche Eisenbahnstrecken entsprechen, wobei OCS Streckentrenner (FDQ) und Unterabschnittspfosten (KB) zwischen den Abschnitten (FD) hinzugefügt werden; wobei die Unterabschnittspfosten (KB) einen Schutzschalter (DL), einen Stromwandler (LH), einen Spannungswandler (YH) und eine Mess- und Steuereinheit (CK) umfassen; wobei der Schutzschalter (DL) und der Stromwandler (LH) in Reihe geschalten sind, und der Schutzschalter (DL) und der Stromwandler (LH) mit dem OCS Streckentrenner (FDQ) parallel geschalten sind, wobei der OCS Streckentrenner (FDQ) in dem Traktionsnetzwerk kaskadiert, welches den Zug kontinuierlich mit Elektrizität durchfahrbar macht; wobei der Schutzschalter (DL) normalerweise im Ein-Zustand ist; wobei der Spannungswandler (YH) mit dem OCS T parallel geschalten ist; wobei in allen Unterabschnittspfosten die Spannungswandler vom selben Typ und Übersetzungsverhältnis sind, und wobei auch die Stromwandler vom selben Typ und Übersetzungsverhältnis sind;
wobei die Ausgangsklemmen der Mess- und Steuereinheit (CKₖ) mit der Steuereinheit des Schutzschalters (DLₖ) in dem Unterabschnittspfosten (KBₖ) verbunden sind; wobei jede Mess- und Steuereinheit mit den Traktionsumspannwerken oder dem Traktionsverteilungszentrum durch ein Übertragungsnetzwerk verbunden ist; wobei der Betrag der Stromstärkedifferenz zwischen der an der Sekundärseite des Stromwandlers (LHₖ) in dem Unterabschnittspfosten (KBₖ) und der Sekundärseite des Stromwandlers (LHₖ₋ᵢ) in dem linksangrenzenden Unterabschnittspfosten (KBₖ₋ᵢ) gemessenen Stromstärke als longitudinaler Differenzstrom (I_{z}) definiert ist, wobei der Betrag der Stromstärkedifferenz zwischen der an der Sekundärseite des Stromwandlers (LHₖ) in dem Unterabschnittspfosten (KBₖ) und der Sekundärseite des Stromwandlers (LHₖ₊ᵢ) in dem rechtsangrenzenden Unterabschnittspfosten (KBₖ₊ᵢ) gemessenen Stromstärke als longitudinaler Differenzstrom (I_{y}) definiert ist;
**dadurch gekennzeichnet, dass** die Sekundärseite des Spannungswandlers (YHₖ) und die Sekundärseite des Stromwandlers (LHₖ) in dem Unterabschnittspfosten (KBₖ), die Sekundärseite des Stromwandlers (LHₖ₋ᵢ) in dem linksangrenzenden Unterabschnittspfosten (KBₖ₋ᵢ), die Sekundärseite des Stromwandlers (LHₖ₊ᵢ) in dem rechtsangrenzenden Unterabschnittspfosten (KBₖ₊ᵢ) alle mit den Eingangsklemmen der Mess- und Steuereinheit (CKₖ ) verbunden sind;
wobei die Mess- und Steuereinheit (CKₖ) ermittelt, ob ein Kurzschlussfehler in dem OCS in Abschnitt (FDₖ) entsprechend dem longitudinaler Differenzstrom (I_{z}) und (UTₖ) zwischen dem Unterabschnittspfosten (KBₖ) und dem linksangrenzenden Unterabschnittspfosten (KBₖ₋ᵢ) auftritt, wobei die Spannung an dem OCS an der Sekundärseite des Spannungswandlers (YHₖ) im Unterabschnittspfosten (KBₖ) gemessen wird, wobei die Mess- und Steuereinheit (CKₖ) bei einem Kurzschlussfehler die Steuerklemmen des Schutzschalters (DLₖ) in dem Unterabschnittspfosten (KBₖ) zum Ausschalten des Schutzschalters (DLₖ) verursacht und ansonsten der Schutzschalters (DLₖ) im Ein-Zustand verbleibt;
wobei die Mess- und Steuereinheit (CKₖ) ermittelt, ob ein Kurzschlussfehler in dem OCS in Abschnitt (FDₖ₊ᵢ) entsprechend dem longitudinalen Differenzstrom (I_{y}) und (UTₖ) zwischen dem Unterabschnittspfosten (KBₖ) und dem rechtsangrenzenden Unterabschnittspfosten (KBₖ₊ᵢ) auftritt, wobei die Spannung an dem OCS an der Sekundärseite des Spannungswandlers (YHₖ) im Unterabschnittspfosten (KBₖ) gemessen wird, wobei die Mess- und Steuereinheit (CKₖ) bei einem Kurzschlussfehler die Steuerklemmen des Schutzschalters (DLₖ) in dem Unterabschnittspfosten (KBₖ) zum Ausschalten des Schutzschalters (DLₖ) verursacht und ansonsten der Schutzschalters (DLₖ) im Ein-Zustand verbleibt.

2. Das verteilte Schutzsystem zur Energieversorgung an Abschnitten eines elektrifizierten Eisenbahnantriebsystems nach Anspruch 1, wobei die Mess- und Steuereinheit CKₖ ermittelt, ob ein Kurzschlussfehler in dem OCS in Abschnitt FDₖ entsprechend dem longitudinalen Differenzstrom I_{z} und U_{Tk} zwischen dem Unterabschnittspfosten KBₖ und dem linksangrenzenden Unterabschnittspfosten KBₖ₋₁ auftritt, wobei die Spannung an dem OCS an der Sekundärseite des Spannungswandlers YHₖ im Unterabschnittspfosten KBₖ gemessen wird, wobei das verteilte Schutzsystem umfasst:
die Mess- und Steuereinheit CKₖ ermittelt, dass ein Kurzschlussfehler in dem OCS in Abschnitt FDₖ zwischen dem Unterabschnittspfosten KBₖ und dem linksangrenzenden Unterabschnittspfosten KBₖ₋₁ auftritt, unter der Voraussetzung dass der longitudinale Differenzstrom I_{z} nicht kleiner ist als l_{dz}, dem Sollwert des longitudinalen Differenzstroms, wobei derweil U_{Tk}, die Spannung an dem OCS, die an der Sekundärseite des Spannungswandlers YHₖ im Unterabschnittspfosten KBₖ gemessen wird, kleiner ist als der spezifische Wert U_{dz}.

3. Das verteilte Schutzsystem zur Energieversorgung an Abschnitten eines elektrifizierten Eisenbahnantriebsystems nach Anspruch 1, wobei die Mess- und Steuereinheit CKₖ ermittelt, ob ein Kurzschlussfehler in dem OCS in Abschnitt FDₖ₊₁ entsprechend dem longitudinalen Differenzstrom I_{y} und U_{Tk} zwischen dem Unterabschnittspfosten KBₖ und dem rechtsangrenzenden Unterabschnittspfosten KBₖ₊₁ auftritt, wobei die Spannung an dem OCS an der Sekundärseite des Spannungswandlers YHₖ im Unterabschnittspfosten KBₖ gemessen wird, wobei das verteilte Schutzsystem umfasst:
die Mess- und Steuereinheit CKₖ ermittelt, dass ein Kurzschlussfehler in dem OCS in Abschnitt FDₖ₊₁ zwischen dem Unterabschnittspfosten KBₖ und dem rechtsangrenzenden Unterabschnittspfosten KBₖ₊₁ auftritt, unter der Voraussetzung dass der longitudinale Differenzstrom I_{y} nicht kleiner ist als l_{dz}, dem Sollwert des longitudinalen Differenzstroms, wobei derweil Urₖ, die Spannung an dem OCS, die an der Sekundärseite des Spannungswandlers YHₖ im Unterabschnittspfosten KBₖ gemessen wird, kleiner ist als der spezifische Wert U_{dz}.

4. Das verteilte Schutzsystem zur Energieversorgung an Abschnitten eines elektrifizierten Eisenbahnantriebsystems nach Anspruch 2 oder 3, wobei l_{dz}, der Sollwert des longitudinalen Differenzstroms, 0,8A oder 0A ist, wobei der spezifische Wert U_{dz} 18kV ist.

## Revendications

1. Système de protection distribué pour le réseau d'alimentation électrique segmenté dans un chemin de fer électrifié, dans lequel le système de protection distribué pour le réseau d'alimentation électrique segmenté dans un chemin de fer électrifié comprend :
l'OCS, système de contact aérien, d'un réseau de traction dans un chemin de fer électrifié est divisé en plusieurs segments (FD) correspondant à des sections de chemin de fer, en ajoutant des sectionneurs d'OCS (FDQ) et des postes de sous-section (KB) entre les segments (FD) ; le poste de sous-section (KB) inclut un disjoncteur (DL), un transformateur de courant (LH), un transformateur de potentiel (YH) et une unité de mesure et de commande (CK) ; le disjoncteur (DL) et le transformateur de courant (LH) se connectent en série, et le disjoncteur (DL) et le transformateur de courant (LH) sont connectés en parallèle avec le sectionneur d'OCS (FDQ), le sectionneur d'OCS (FDQ) étant en cascade dans le réseau de traction, ce qui amène les trains à circuler en continu à l'électricité ; le disjoncteur (DL) est normalement dans un état passant ; le transformateur de potentiel (YH) se connecte au T de l'OCS en parallèle ; dans tous les postes de sous-section, les transformateurs de potentiel sont de type et de rapport de transformation identiques, et les transformateurs de courant sont également de type et de rapport de transformation identiques ;
dans lequel les bornes de sortie de l'unité de mesure et de commande (CKₖ) sont connectées à l'unité de commande du disjoncteur (DLₖ) dans le poste de sous-section (KBₖ) ; chaque unité de mesure et de commande est connectée aux sous-stations de traction ou à un centre de répartition au travers d'un réseau de transmission ; la valeur absolue de la différence de courant entre le courant mesuré sur le côté secondaire du transformateur de courant (LHₖ) dans le poste de sous-section (KBₖ) et le côté secondaire du transformateur de courant (LHₖ₋ᵢ) dans le poste de sous-section (KBₖ₋ᵢ) adjacent à gauche est défini comme étant un courant différentiel longitudinal (I_{z}), la valeur absolue de la différence de courant entre le courant mesuré sur le côté secondaire du transformateur de courant (LHₖ) dans le poste de sous-section (KBₖ) et le côté secondaire du transformateur de courant (LHₖ₊ᵢ) dans le poste de sous-section (KBₖ₊ᵢ) adjacent à droite est défini comme étant un courant différentiel longitudinal (I_{y}) ;
**caractérisé en ce que** le côté secondaire du transformateur de potentiel (YHₖ) et le côté secondaire du transformateur de courant (LHₖ) dans le poste de sous-section (KBₖ), le côté secondaire du transformateur de courant (LHₖ₋ᵢ) dans le poste de sous-section (KBₖ₋ᵢ) adjacent à gauche, le côté secondaire du transformateur de courant (LHₖ₊ᵢ) dans le poste de sous-section (KBₖ₊ᵢ) adjacent à droite sont tous connectés aux bornes d'entrée de l'unité de mesure et de commande (CKₖ) ;
l'unité de mesure et de commande (CKₖ) identifie si un défaut de court-circuit est en cours dans l'OCS dans un segment (FDₖ) entre le poste de sous-section (KBₖ) et le poste de sous-section (KBₖ₋ᵢ) adjacent à gauche d'après le courant différentiel longitudinal (I_{z}) et (UTₖ), la tension sur OCS mesurée sur le côté secondaire du transformateur de potentiel (YHₖ) dans le poste de sous-section (KBₖ), l'unité de mesure et de commande (CKₖ) pilote les bornes de commande du disjoncteur (DLₖ) dans le poste de sous-section (KBₖ) afin de bloquer le disjoncteur (DLₖ) si un défaut de court-circuit est présent, dans le cas contraire, le disjoncteur (DLₖ) restera dans l'état passant ;
l'unité de mesure et de commande (CKₖ) identifie si un défaut de court-circuit est en cours dans l'OCS dans un segment (FDₖ₊ᵢ) entre le poste de sous-section (KBₖ) et le poste de sous-section (KBₖ₊ᵢ) adjacent à droite d'après le courant différentiel longitudinal (I_{y}) et (UTₖ) la tension sur OCS mesurée sur le côté secondaire du transformateur de potentiel (YHₖ) dans le poste de sous-section (KBₖ), l'unité de mesure et de commande (CKₖ) pilote la borne de commande du disjoncteur (DLₖ) dans le poste de sous-section (KBₖ) afin de bloquer le disjoncteur (DLₖ) si un défaut de court-circuit est présent, dans le cas contraire, le disjoncteur (DLₖ) restera dans l'état passant.

2. Système de protection distribué pour le réseau d'alimentation électrique segmenté dans un chemin de fer électrifié selon la revendication 1, dans lequel l'unité de mesure et de commande CKₖ identifie si un défaut de court-circuit est en cours dans l'OCS dans un segment FDₖ entre le poste de sous-section KBₖ et le poste de sous-section KBₖ₋₁ adjacent à gauche d'après le courant différentiel longitudinal I_{z} et U_{Tk}, la tension sur OCS mesurée sur le côté secondaire du transformateur de potentiel YHₖ dans le poste de sous-section KBₖ, comprend :
l'unité de mesure et de commande CKₖ identifie qu'un défaut de court-circuit est en cours dans l'OCS dans un segment FDₖ entre le poste de sous-section KBₖ et le poste de sous-section KBₖ₋₁ adjacent à gauche, à condition que le courant différentiel longitudinal I_{z} ne soit pas inférieur à I_{dz}, la valeur de consigne de courant différentiel longitudinal, et dans le même temps, U_{Tk}, la tension sur OCS mesurée sur le côté secondaire du transformateur de potentiel YHₖ dans le poste de sous-section KBₖ, soit inférieure à la valeur spécifique U_{dz}.

3. Système de protection distribué pour le réseau d'alimentation électrique segmenté dans un chemin de fer électrifié selon la revendication 1, dans lequel l'unité de mesure et de commande CKₖ identifie si un défaut de court-circuit est en cours dans l'OCS dans un segment FDₖ₊₁ entre le poste de sous-section KBₖ et le poste de sous-section KBₖ₊₁ adjacent à droite d'après le courant différentiel longitudinal I_{y} et U_{Tk}, la tension sur OCS mesurée sur le côté secondaire du transformateur de potentiel YHₖ dans le poste de sous-section KBₖ, comprend :
l'unité de mesure et de commande CKₖ identifie qu'un défaut de court-circuit est en cours dans l'OCS dans un segment FDₖ₊₁ entre le poste de sous-section KBₖ et le poste de sous-section KBₖ₊₁ adjacent à droite, à condition que le courant différentiel longitudinal I_{y} ne soit pas inférieur à I_{dz}, la valeur de consigne de courant différentiel longitudinal, et dans le même temps, U_{Tk}, la tension sur OCS mesurée sur le côté secondaire du transformateur de potentiel YHₖ dans le poste de sous-section KBₖ, soit inférieure à la valeur spécifique U_{dz}.

4. Système de protection distribué pour le réseau d'alimentation électrique segmenté dans un chemin de fer électrifié selon la revendication 2 ou 3, dans lequel I_{dz}, la valeur de consigne de courant différentiel longitudinal, est 0,8 A ou 0 A, la valeur spécifique U_{dz} est 18 kV.
